# EUROPÄISCHE PATENTSCHRIFT

(11) **EP 1 768 182 B1**
(45) Veröffentlichungstag und Bekanntmachung des Hinweises auf die Patenterteilung: **22.06.2011**
(21) Anmeldenummer: 06020214.0
(22) Anmeldetag: 27.09.2006
(51) Int. Cl.: H01L 23/62, H01L 25/07, H01L 23/373, H01L 23/24

(54) **Leistungshalbleitermodul mit Überstromschutzeinrichtung**
Semiconductor power module with overcurrent protection means
Module semi-conducteur de puissance avec dispositif de protection contre les surintensités de courant

(30) Priorität: 27.09.2005 DE 10546063
(43) Veröffentlichungstag der Anmeldung: 28.03.2007
(73) Patentinhaber: Semikron Elektronik GmbH & Co. KG Patentabteilung, 90431 Nürnberg (DE)
(72) Erfinder: Kroneder, Christian, 90596 Schwanstetten (DE); Schreiber, Dejan, 90408 Nürnberg (DE); Scheuermann, Uwe, Dr., 90439 Nürnberg (DE)

(56) Entgegenhaltungen:
- EP-A- 0 411 405
- EP-A- 1 474 828
- DE-B3- 10 316 355
- JP-A- 3 214 657
- US-A- 5 744 860
- US-B1- 6 424 035

## Beschreibung

### Beschreibung

Die Erfindung beschreibt ein Leistungshalbleitermodul bestehend aus einem Gehäuse vorzugsweise mit einer Grundplatte zur Montage auf einem Kühlkörper und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weist das Leistungshalbleitermodul Anschlusselemente für externe Last- und Hilfskontakte und auch Verbindungselemente für Verbindungen im Inneren des Leistungshalbleitermoduls auf.

Leistungshalbleitermodule, die Ausgangspunkt dieser Erfindung sind, sind beispielhaft bekannt aus der DE 103 16 355 B3. Diese Druckschrift offenbart ein Leistungshalbleitermodul in Form einer Halbbrückenschaltungsanordnung mit einem ersten und einem zweiten Leistungsschalter. Jeder dieser Leistungsschalter ist ausgebildet als eine Parallelschaltung von Leistungstransistoren mit jeweils einer zugeordneten Freilaufdiode. Je ein erster und ein zweiter Leistungstransistor mit zugeordneter Leistungsdiode ist hierbei auf einem eigenen Substrat angeordnet.

Gemäß der als Stand der Technik genannten Druckschrift sind die Substrate derartiger Leistungshalbleitermodule ausgebildet als isolierende Substrate bestehend aus einem Isolierstoffkörper als Trägermaterial und zur elektrischen Isolierung gegen eine Grundplatte oder einen Kühlkörper. Dieser Isolierstoffkörper besteht nach dem Stand der Technik aus einer Industriekeramik beispielhaft Aluminiumoxid oder Aluminiumnitrit. Auf diesem lsolierstoffkörper, auf dessen dem Inneren des Leistungshalbleitermoduls zugewandten ersten Hauptfläche, befindet sich eine Mehrzahl von gegeneinander elektrisch isolierten metallischen Verbindungsbahnen. Auf diesen wiederum sind die Leistungshalbleiterbauelemente angeordnet.

Meist weist der Isolierstoffkörper auf seiner dem Inneren des Leistungshalbleitermoduls abgewandten zweiten Hauptfläche ebenfalls eine metallische Schicht gleichen Materials und gleicher Dicke wie diejenige der Verbindungsbahnen auf der ersten Hauptfläche auf. In der Regel ist diese Schicht allerdings nicht in sich strukturiert, da sie beispielhaft der Lötverbindung zu einer Grundplatte dient. Die Verbindungsbahnen sowie die metallische Schicht der zweiten Hauptfläche besteht vorzugsweise aus nach dem DCB (direct copper bonding) Verfahren aufgebrachten Kupfer, wobei das Kupfer hierbei eine typische Dicke von weniger als 1 mm aufweist.

Weiterhin weisen die genannten Leistungshalbleitermodule nach dem Stand der Technik Lastanschlusselemente für die beiden Gleichstromanschlüsse und für den mindestens einen Wechselstromanschluss auf. Die Lastanschlusselemente verbinden äußere Kontaktierungen mit zugeordneten Verbindungsbahnen auf dem Substrat.

Zur Inneren Isolation sind Leistungshalbleitermodule nach dem Stand der Technik bis oberhalb der Verbindungselemente mit einer Vergussmasse mit hoher Dielektrizitätskonstante vergossen.

Moderne Leistungshalbleiterbauelemente, besonders Leistungstransistoren, weisen im Zuge des technologischen Fortschritts eine stetig wachsende Stromdichte auf. Typische Verbindungselemente zwischen den Leistungshalbleiterbauelementen und den Verbindungsbahnen sind Bondverbindungen und hier speziell Drahtbondverbindungen. Nach dem Stand der Technik werden verschiedene Fehlerszenarien beim Einsatz von Leistungshalbleitermodulen durch geeignete Sensoren im oder in der Beschaltung des Leistungshalbleitermoduls erfasst und durch die Ansteuerelektronik Gegenmaßnahmen, wie beispielsweise das Abschalten der Leistungsschalter, eingeleitet. Es gibt allerdings auch Fehlerszenarien, die hierdurch nicht oder nicht vollständig erfasst werden. In diesen Fällen entsteht im Inneren des Leistungshalbleitermoduls ein kurzzeitig fließender Überstrom, der die Bonddrähte überlastet. Dieser Überstrom führt zum Schmetzenmindestens eines Bonddrahtes, wobei durch die vorhandenen Induktivitäten der Stromfluss in Form eines Lichtbogens aufrecht erhalten bleibt. Dies führt bei Leistungshalbleitermodulen mit Vergussmasse auf Grund der in dem kurzen Zeitintervall fehlenden Kompressibilität dieser Vergussmasse und des sich somit schnell aufbauenden inneren Drucks häufig zu einer Explosion des Leistungshalbleitermoduls.

Der Erfindung liegt die Aufgabe zugrunde ein Leistungshalbleitermodul weiterzubilden mit einer im Inneren des Leistungshalbleitermoduls angeordneten Schutzeinrichtung um eine durch zu hohe Ströme bedingte explosionsartige Zerstörung des Leistungshalbleitermoduls zu verhindern.

Die Schutzeinrichtung gegen zu hohe Ströme im Inneren des Leistungshalbleitermoduls soll im Folgenden vereinfachend als Sicherungseinrichtung bezeichnet werden.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul vorzugsweise mit einer Grundplatte zur Montage auf einem Kühlkörper. Dieses Leistungshalbleitermodul weist mindestens folgende Komponenten auf: ein Gehäuse, Anschlusselemente für Last- und Hilfsanschlüsse, mindestens ein Substrat mit Verbindungsbahnen und mindestens einem Leistungshalbleiterbauelement.

Die Anschlusselemente für Lastanschlüsse führen aus dem Gehäuse heraus und dienen der elektrischen Verbindung der im Gehäuseinneren angeordneten Leistungshalbleiterbauelemente. Das zur Grundplatte oder einem Kühlkörper elektrisch isolierend ausgebildeten Substrat besteht seinerseits aus einem Isolierstoffkörper, vorzugsweise einer Industriekeramik, und hierauf, auf dessen der Grundplatte oder dem Kühlkörper abgewandten ersten Hauptfläche befindlich, einer Mehrzahl von gegeneinander elektrisch isolierten metallischen Verbindungsbahnen. Auf diesen Verbindungsbahnen sind Leistungshalbleiterbauelemente angeordnet und schaltungsgerecht mittels ersten Verbindungselementen mit einem ersten Leitungsquerschnitt verbunden. Vorzugsweise sind diese ersten Verbindungselemente als Bondverbindungen mit einer Mehrzahl einzelner Bonddrähte ausgestaltet. Eine derartige Bondverbindung weist einen ersten Leitungsquerschnitt auf, der gebildet wird durch die Summe der Querschnittsflächen aller Bonddrähte der Bondverbindung.

Das Leistungshalbleitermodul weist in seinem Inneren mindestens eine Sicherungseinrichtung auf, wobei diese Sicherungseinrichtung aus einem zweiten Verbindungselement mit einem zweiten, gegenüber dem ersten geringeren, Leitungsquerschnitt besteht. Die Sicherungseinrichtung ist zwischen zwei Verbindungsbahnen und / oder zwischen einer Verbindungsbahn und einem Lastanschlusselement angeordnet. Weiterhin ist dieses zweite Verbindungselement in einem Teilabschnitt vollständig von einem Explosionsschutzmittel umhüllt. Dieses Explosionsschutzmittel erlaubt eine kontrollierte Ausbildung eines Lichtbogens, ohne dass es hierbei in diesem Explosionsschutzmittel zu einem sehr schnellen Druckanstieg führt, der in einer Explosion endet.

Die erfinderische Lösung wird an Hand der Fig. 1 bis 3 weiter erläutert.

Fig. 1 zeigt eine Schaltungstopologie eines Leistungshalbleitermoduls nach dem Stand der Technik.

Fig. 2 zeigt eine Schaltungstopologie eines erfindungsgemäßen Leistungshalbleitermoduls.

Fig. 3 zeigt eine Ausgestaltung eines erfindungsgemäßen Leistungshalbleitermoduls.

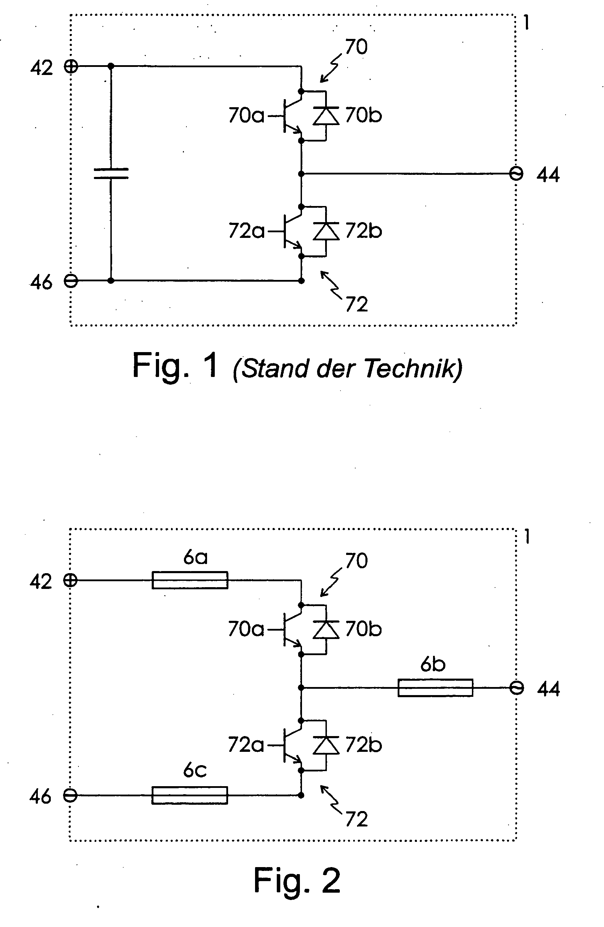

Fig. 1 zeigt eine Schaltungstopologie eines Leistungshalbleitermoduls (1) nach dem Stand der Technik. Dargestellt ist hier eine Halbbrückenschaltung wie sie Grundbaustein vieler leistungselektronischer Schaltungstopologien ist. Hierbei ist ein erster, oberer, Leistungsschalter (70) mit einem zweiten unteren Leistungsschalter (72) in Reihe geschalten. Der erste Leistungsschalter (70) ist mit dem positiven Anschluss (42) eines Gleichstromzwischenkreises verbunden. Der zweite Leistungsschalter (72) ist mit dem negativen Anschluss (46) des Gleichstromzwischenkreises verbunden. Der Mittelabgriff der Schaltung bildet den Wechselstromausgang (44) der Halbbrückenschaltung.

Die Leistungsschalter (70,72) sind ausgebildet als eine Anordnung von mindestens einem Leistungstransistor (70a, 72a) und mindestens einer hierzu antiparallel geschalteten Leistungsdiode (70b, 72b).

Fig. 2 zeigt eine Schaltungstopologie eines erfindungsgemäßen Leistungshalbleitermoduls (1). Die dargestellte Schaltungstopologie ist ebenfalls die Halbbrückenschaltung. Gleichwohl ist der erfinderische Gedanke in jeglicher anderen Schaltungstopologie einsetzbar. Erfindungsgemäß ist das auf dieser Schaltung basierende Leistungshalbleitermodul (1) weitergebildet, indem mindestens eine, hier drei, Sicherungseinrichtungen (6 a/b/c) in die Schaltung eingebunden sind.

Eine vorteilhafte Ausgestaltung ist hierbei die Anordnung einer Sicherungseinrichtung (6b) zwischen dem Mittelabgriff und dem Wechselstromanschluss (44).

Eine weitere vorteilhafte Ausgestaltung ordnet je eine Sicherung (6a, 6c) zwischen dem jeweiligen Gleichstromanschluss (42, 46) und dem zugeordneten Leistungsschalter (70, 72) an.

Die Anordnung von drei Sicherungseinrichtungen (6 a/b/c) innerhalb eines Leistungshalbleitermoduls (1) ist die aufwendigste, aber zugleich sicherste Ausgestaltung der Erfindung. Die Anordnung nur einer Sicherungseinrichtung (6 a/b/c) kann nicht vor allen möglichen Ausfallszenarien schützen, bildet aber einen sinnvollen Kompromiss aus Aufwand und Nutzen.

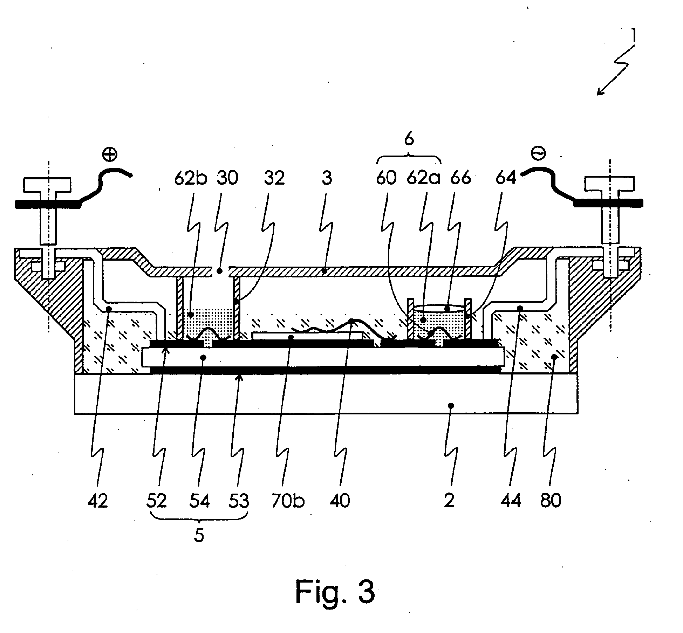

Fig. 3 zeigt ein erfindungsgemäßes Leistungshalbleitermodul (1). Dieses weist eine Grundplatte (2) auf, worauf das Gehäuse (3) sowie ein Substrat (5) angeordnet sind. Das Substrat (5) besteht aus einem Isolierstoffkörper (54) sowie aus metallischen Kaschierungen, die auf beiden Hauptflächen angeordnet sind. Die der Grundplatte (2) zugewandte metallische Kaschierung (53) ist flächig ausgebildet und in sich nicht strukturiert. Mittels einer Lötverbindung zwischen dieser Kaschierung (53) und der Grundplatte (2) werden diese zueinander fixiert. Demgegenüber ist die dem Leistungshalbleitermodulinneren zugewandte Kaschierung in sich strukturiert und bildet somit die Verbindungsbahnen (52) des Substrats (5) aus.

Die Anschlusselemente, hier dargestellt ein Gleichstromanschluss (42) positiver Polarität und ein Wechselstromanschluss (44), werden gebildet durch Metallformkörper, die an ihrem einen Ende löttechnisch mit der zugeordneten Verbindungsbahn (52) verbunden sind und an ihrem anderen Ende eine Ausnehmung zur Schraubverbindung aufweisen.

Auf diesen Verbindungsbahnen (52) sind die Leistungshalbleiterbauelemente (70, 72), hier dargestellt eine Leistungsdiode (70b), angeordnet. Die elektrischen Anschlusselemente bilden die Leistungs- (42, 44) und die nicht explizit dargestellten Hilfsanschlüsse. Die schaltungsgerechte Verbindung der Leistungshalbleiterbauelemente (70, 72), hier die Leistungsdiode (70b) gemäß der Schaltungstopologie nach Fig. 2 mit den Verbindungsbahnen (52) ist als Bondverbindung (40) ausgebildet. Beispielhaft weist diese Bondverbindung zehn einzelne Bonddrähte mit einem Durchmesser von je 300µm auf, wodurch sich ein erster Leitungsquerschnitt der Verbindung zu diesem Leistungshalbleiterbauelement von ca. 0,71 mm² ergibt.

Weiterhin dargestellt sind zwei Ausführungsformen der erfindungsgemäßen Sicherungseinrichtung (6) des Leistungshalbleitermoduls (1). Die erste Ausgestaltung weist eine Bondverbindung (60) zwischen der Leiterbahn (52) des positiven Anschlusses und der Leiterbahn (52) der Leistungsdiode (70b), die hierauf kathodenseitig angeordnet ist, auf. Diese Bondverbindung (60) ist ausgebildet mittels 5 Bonddrähten mit einem Durchmesser von je 300µm. Somit ergibt sich ein zweiter Leitungsquerschnitt, der 50 von 100 des ersten Leitungsquerschnitts beträgt. Besonders vorteilhaft ist es, wenn dieser zweite Leitungsquerschnitt zwischen 40 von 100 und 60 von 100 des ersten Leitungsquerschnitts beträgt. Dieser deutlich geringer zweite Leitungsquerschnitt ist ausreichend, da bei kurzzeitigem Stromfluss, einem sog. Stoßstrom, ausschließlich der Leitungsquerschnitt die bestimmende Größe ist. Im Vergleich hierzu wird die Ausgestaltung der Bondverbindungen zu den Leistungshalbleiterbauelementen durch weitere Größen, wie beispielhaft die Stromverteilung auf dem Leistungshalbleiterbauelement, bestimmt. Daher sind diese Verbindungen typischerweise mit einem deutlich größeren Leitungsquerschnitt ausgebildet als dies zur Tragfähigkeit eines Stoßstroms notwendig wäre.

Die dieses zweite Verbindungselement (60) bildenden Bonddrähte sind abgesehen von ihrer jeweiligen Kontaktfläche mit der zugeordneten Leiterbahn (52) von Siliziumoxid (62) als Explosionsschutzmittel umgeben. Diese Siliziumdioxid (62) weist vorteilhafterweise ein Korngröße zwischen 50µm und 2mm auf. Das Siliziumoxid liegt hierbei als reiner Stoff (62a) oder als Stoffgemisch (62b) mit einer Mindestkonzentration an Siliziumoxid von 90 von 100 vor.

Es ist besonders bevorzugt, wenn dem Siliziumoxid (62b) ein Bindemittel beigefügt ist. Hierdurch ist eine Abdeckung des Siliziumoxids (62b) nicht unbedingt erforderlich, weil es in gebundener Form die Bonddrähte (60) umschließt und somit in seiner Lage im Leistungshalbleitermodul (1) fixiert ist.

Die Bonddrähte (60) mit dem Explosionsschutzmittel (62) sind von einer rahmenartigen Anordnung (32) umgeben, die hier als Gehäuseteil ausgebildet ist und auf dem Substrat (5) mittels einer Klebeverbindung angeordnet ist. Somit ist ein Kontakt zwischen dem Explosionsschutzmittel (62) und der Vergussmasse, vorzugsweise einem Silikonkautschuk (80), verhindert. Weiterhin weist das Gehäuse (3) an seiner Oberseite eine geeignete Ausnehmung (30) zur Befüllung des Leistungshalbleitermoduls mit dem Explosionsschutzmittel (62) auf.

Die zweite dargestellte Ausgestaltung zeigt eine rahmenartige Begrenzungseinrichtung (64), vorzugsweise aus einem Kunststoffmaterial, die klebtechnisch mit dem Substrat (5) verbunden ist. Im Inneren dieser Begrenzungseinrichtung (64) sind die Bondverbindung sowie das Explosionsschutzmittel (60) angeordnet. Falls diese keinen Zusatz eines Bindemittels aufweist ist hierbei ein Verschlussmittel (66), beispielhaft ein Epoxydharz vorgesehen um das Explosionsschutzmittel (60a) in der vorgesehenen Lage zu fixieren.

## Patentansprüche

1. Leistungshalbleitermodul (1) mit mindestens einer Sicherungseinrichtung (6), wobei das Leistungshalbleitermodul mindestens besteht aus einem Gehäuse (3), nach außen führenden Lastanschlusselementen (42, 44, 46), mindestens einem innerhalb des Gehäuses (3) angeordneten elektrisch isolierenden Substrat (5), wobei diese bestehen aus einem Isolierstoffkörper (54) mit auf einer dem Inneren des Leistungshalbleitermoduls zugewandten ersten Hauptfläche befindlichen Mehrzahl von gegeneinander elektrisch isolierten metallischen Verbindungsbahnen (52) unterschiedlicher Polarität, mit mindestens einem auf einer dieser Verbindungsbahnen (52) angeordneten Leistungshalbleiterbauelement (70 ,72) mit ersten Verbindungselementen (40) mit einem ersten Leitungsquerschnitt zu dessen schaltungsgerechter Verbindung,
**dadurch gekennzeichnet,**
**dass** die Sicherungseinrichtung (6) besteht aus einem zweiten Verbindungselement (60) mit einem zweiten, gegenüber dem ersten geringeren, Leitungsquerschnitt, angeordnet zwischen zwei Verbindungsbahnen (52) und / oder zwischen einer Verbindungsbahn (52) und einem Lastanschlusselement (42, 44, 46), wobei dieses zweite Verbindungselement (60) in einem Teilabschnitt von einem Explosionsschutzmittel (62) umhüllt ist.

2. Leistungshalbleitermodul (1) nach Anspruch 1,
wobei das erste Verbindungselement (40) und / oder das zweite Verbindungselemente (60) ausgebildet ist als je eine Bondverbindung mit einer Mehrzahl einzelner gleichartiger Bonddrähte.

3. Leistungshalbleitermodul (1) nach Anspruch 1
wobei das zweite Verbindungselement (60) und das Explosionsschutzmittel (62) der Sicherungseinrichtung von einem rahmenartigen Gehäuseteil (32) oder von einer rahmenartigen Begrenzungseinrichtung (64) umschlossen ist.

4. Leistungshalbleitermodul (1) nach Anspruch 3
wobei der rahmenartige Gehäuseteil (32) oder die rahmenartige Begrenzungseinrichtung (64) der Sicherungseinrichtung (6) auf der dem Substrat (5) abgewandten Seite oberhalb des Explosionsschutzmittels (62) eine Verschlusseinrichtung (66) aufweist.

5. Leistungshalbleitermodul (1) nach Anspruch 3
wobei der rahmenartige Gehäuseteil (32) oder die rahmenartige Begrenzungseinrichtung (64) der Sicherungseinrichtung (6) mittels einer Klebeverbindung mit dem Substrat (5) verbunden ist.

6. Leistungshalbleitermodul (1) nach Anspruch 3
wobei das Gehäuse (3) im Bereich des rahmenartigen Gehäuseteils (32) ein Ausnehmung (30) aufweist.

7. Leistungshalbleitermodul (1) nach Anspruch 1
wobei das Explosionsschutzmittel (62) zu mehr als 90 von 100 aus Siliziumdioxid mit einer Korngröße des Explosionsschutzmittels zwischen 50µm und 2mm besteht.

8. Leistungshalbleitermodul (1) nach Anspruch 7
wobei dem Explosionsschutzmittel (62) ein Bindemittel beigefügt ist.

9. Leistungshalbleitermodul (1) nach Anspruch 1
wobei der zweite Leitungsquerschnitt des zweiten Verbindungselements (60) zwischen 40 von 100 und 60 von 100 des ersten Leitungsquerschnitts des ersten Verbindungselements (40) beträgt.

10. Leistungshalbleitermodul (1) nach Anspruch 1
wobei das Leistungshalbleitermodul (1) eine Halbbrückenschaltung ausbildet und die Sicherungseinrichtung (6 a/b/c) zwischen mindestens einem Lastanschluss (42, 44, 46) und einem Leistungshalbleiterbauelement (70, 72) angeordnet ist.

## Claims

1. A power semi-conductor module (1) comprising at least one fuse-type device (6), wherein the power semi-conductor module consists at least of a housing (3), load connection elements (42, 44, 46) leading to the outside, at least one electrically insulating substrate (5) arranged inside housing (3), wherein these consist of an insulation body (54) with a plurality of mutually insulated metallic connecting tracks (52) of different polarity arranged on a first main surface facing the inside of the power semi-conductor module, with at least one power semi-conductor component (70, 72) arranged on one of these connecting tracks (52) with first connecting elements (40) having a first wire cross-section in relation to its circuit-suitable connection,
**characterised in that**
the fuse-type device (6) consists of a second connecting element (60) having a second wire cross-section smaller in relation to the first wire cross-section, arranged between two connecting tracks (52) and/or between one connecting track (52) and a load connection element (42, 44, 46), wherein this second connecting element (60), in one section, is enclosed by an explosion-protection means (62).

2. The power semi-conductor module (1) according to claim 1, wherein the first connecting element (40) and/or the second connecting element (60) is formed as a bond connection with a plurality of individual bond wires of the same kind.

3. The power semi-conductor module (1) according to claim 1, wherein the second connecting element (60) or the explosion-protection means (62) of the fuse-type device is enclosed by a frame-type housing part (32) or by a frame-type limiting device (64).

4. The power semi-conductor module (1) according to claim 3, wherein the frame-type housing part (32) or the frame-type limiting device (64) of the fuse-type device (6) comprises a closure device (66) on the side facing away from the substrate (5) above the explosion-protection means (62).

5. The power semi-conductor module (1) according to claim 3, wherein the frame-type housing part (32) or the frame-type limiting device (64) of the fuse-type device (6) is connected with the substrate (5) by means of an adhesive bond.

6. The power semi-conductor module (1) according to claim 3, wherein the housing (3) comprises a recess (30) in the area of the frame-type housing part (32).

7. The power semi-conductor module (1) according to claim 1, wherein more than 90% of the explosion-protection means (62) consists of silicon dioxide with a grain size of the explosion-protection means between 50µm and 2mm.

8. The power semi-conductor module (1) according to claim 7, wherein a binding agent is added to the explosion-protection means (62).

9. The power semi-conductor module (1) according to claim 1, wherein the second wire cross-section of the second connecting element (60) is between 40% and 60% of the first wire cross-section of the first connecting element (40).

10. The power semi-conductor module (1) according to claim 1, wherein the power semi-conductor module (1) forms a half-bridge circuit and the fuse-type device (6 a/b/c) is arranged between at least one load terminal (42, 44, 46) and a power semi-conductor component (70, 72).

## Revendications

1. Module à semi-conducteurs de puissance (1) comprenant au moins un dispositif de sécurité (6), le module à semi-conducteurs de puissance comprenant au moins un boîtier (3), des éléments de raccordement de charge (42, 44, 46) allant vers l'extérieur, au moins un substrat (5) électriquement isolant et disposé à l'intérieur du boîtier (3), ces éléments étant à base d'un corps en matériau isolant (54) doté d'une pluralité de bandes de liaison (52) métalliques, électriquement isolées les unes des autres, de polarité différente, se trouvant sur une première surface principale tournée vers l'intérieur du module à semi-conducteurs de puissance, comprenant au moins un composant à semi-conducteurs de puissance (70, 72) disposé sur l'une de ces bandes de liaison (52) avec des premiers éléments de liaison (40) avec une première section de ligne pour sa liaison conforme au circuit,
**caractérisé en ce que**
le dispositif de sécurité (6) comprend un second élément de liaison (60) avec une seconde section de ligne, plus faible par rapport à la première, disposée entre deux bandes de liaison (52) et/ou entre une bande de liaison (52) et un élément de raccordement de charge (42, 44, 46), ce second élément de liaison (60) étant enveloppé dans un tronçon partiel par un agent antidéflagrant (62).

2. Module à semi-conducteurs de puissance (1) selon la revendication 1,
le premier élément de liaison (40) et/ou le second élément de liaison (60) étant conçu(s) sous forme d'une liaison de bordage avec une pluralité de fils de bordage similaires individuels.

3. Module à semi-conducteurs de puissance (1) selon la revendication 1,
le second élément de liaison (60) et le moyen antidéflagration (62) du dispositif de sécurité étant enfermés par une partie de boîtier (32) du type cadre ou par un dispositif de délimitation (64) de type cadre.

4. Module à semi-conducteurs de puissance (1) selon la revendication 3,
la partie de boîtier (32) de type cadre ou le dispositif de délimitation (64) de type cadre du dispositif de sécurité (6) présentant un dispositif de fermeture (66) sur le côté opposé au substrat (5) au-dessus du moyen antidéflagration (62).

5. Module à semi-conducteurs de puissance (1) selon la revendication 3,
la partie de boîtier (32) de type cadre ou le dispositif de délimitation (64) de type cadre du dispositif de sécurité (6) étant relié au substrat (5) au moyen d'un assemblage collé.

6. Module à semi-conducteurs de puissance (1) selon la revendication 3,
le boîtier (3) présentant un évidement (30) dans la zone de la partie de boîtier (32) de type cadre.

7. Module à semi-conducteurs de puissance (1) selon la revendication 1,
le moyen antidéflagration (62) étant pour plus de 90 % à base de dioxyde de silicium avec une grosseur de grain du moyen antidéflagration comprise entre 50 µm et 2 mm.

8. Module à semi-conducteurs de puissance (1) selon la revendication 7,
un liant étant ajouté au moyen antidéflagration (62).

9. Module à semi-conducteurs de puissance (1) selon la revendication 1,
la seconde section de ligne du second élément de liaison (60) représentant entre 40 % et 60 % de la première section de conduite du premier élément de liaison (40).

10. Module à semi-conducteurs de puissance (1) selon la revendication 1,
le module à semi-conducteurs de puissance (1) formant un circuit en demi-pont et le dispositif de sécurité (6 a/b/c) étant disposé entre au moins un raccordement de charge (42, 44, 46) et un composant à semi-conducteurs de puissance (70, 72).
